# EUROPEAN PATENT SPECIFICATION

(11) **EP 0 688 887 B1**
(45) Date of publication and mention of the grant of the patent: **06.11.2002**
(21) Application number: 95106353.6
(22) Date of filing: 22.08.1991
(51) Int. Cl.: C23C 16/44, H01L 21/00

(54) **Wafer processing reactor**
Reaktor zur Behandlung von Wafern
Réacteur de traitement de plaquettes

(30) Priority: 23.08.1990 US 571957
(43) Date of publication of application: 27.12.1995
(62) Divisional of application: 91114081.2
(73) Proprietor: APPLIED MATERIALS, INC., Santa Clara, California 95052-8039 (US)
(72) Inventor: Anderson, Roger N., San Jose, California 95124 (US); Lindstrom, Paul R., Aptos, California 95003 (US); Johnson, Wayne, Phoenix, Arizona 85044 (US)
(74) Representative: Käck, Jürgen

(56) References cited:
- EP-A- 0 254 651
- EP-A- 0 254 654
- WO-A-89/12703
- WO-A-90/07019
- US-A- 4 731 255
- US-A- 5 221 556
- PATENT ABSTRACTS OF JAPAN vol. 005 no. 063 (E-054) ,28 April 1981 & JP-A-56 013718 (HITACHI LTD) 10 February 1981,

## Description

### Background of the Invention

This invention relates in general to wafer processing reactors and relates more particularly to the supply of reactant gases to reaction chambers of said wafer processing reactors.

To remain price competitive in integrated circuit fabrication it is important to increase continually the throughput of a wafer processing system. Batch processing systems have been used to increase throughput. However, in state of the art devices it is necessary to utilize single wafer processing systems to achieve the processing uniformity needed to achieve state of the art feature sizes. For equipment utilized to achieve state of the art linewidths it is particularly important to achieve as high a uniformity of processing across the wafer as possible.

As the feature size of integrated circuits shrinks and the size of wafers increases, it becomes increasingly important to accurately control the rates of various wafer processing steps to achieve process uniformity across the entire wafer. The uniformity obtained by all process steps, including all plasma processes and chemical vapor deposition processes, are affected by the distribution of process gases within the processing chamber. In many existing systems, process gases are injected into the processing chamber at a point that is remote from the wafer so that a uniform distribution of the gases is achieved before these gases reach the wafer. The wafer is typically located between the remote gas inlets and an exhaust port so that the reactant gases flow past the wafer. To further improve the uniformity of processing, many systems include the ability to rotate the wafer during processing to increase the uniformity of the time-averaged physical and chemical environment of the wafer during processing. However, to achieve improved process control it would be advantageous to have a greater degree of control over the distribution of gases within the reaction chamber than is now available.

WO 89/12703 discloses a wafer processing system comprising a reaction chamber, a slit-shaped gas inlet port for supplying process gases across a substrate in said chamber and a gas supply manifold consisting of mechanical means connected to a plurality of inlets into said inlet port to allow a changeable spatial gas flow distribution of said gas through said inlet port.

In EP-A-254654 a method of chemical vapor deposition is disclosed which method separately passes a processing gas and an inert gas into a deposition chamber so they pass parallel to the surface of the wafer, but the gas inlets are not close to the wafer and thus are free to mix well prior to their reaching the wafer. If the inert gas and the process gas mix prior to their reaching the wafer, the processing gas will be diluted in an unknown way.

In US-A-4731255 a gas-phase groth process and an apparatus for the same is disclosed with separate gas nozzles for incoming gases into a chamber, the nozzles having a plurality of small holes leading to the chamber. One of the gases is a reaction gas and the other gas nozzle, more remote from the wafer, is an inert gas. The gases are fed parallel to the surface of the wafer.

### Summary of the Invention

The aforementioned objective is met by a wafer processing reactor as disclosed in claim 1 and a method as disclosed in claim 6. Preferred embodiments are disclosed in dependent claims.

In accordance with the illustrated preferred embodiment, a gas flow system is presented that enables accurate control of gas flow rates and composition across a wafer during processing, thereby enhancing the ability to control the distribution of wafer processing rates across the wafer. Although this gas flow system is applicable to batch processing systems, it is best implemented in single wafer processing systems. This gas flow system provides the process gases from a gas inlet port adjacent to the wafer(s) so that the flow rates and concentrations of the gases at the wafer can be more accurately controlled. Preferably, the gases are applied near the edge of the wafer at one side of the wafer and flow across the wafer to an exhaust port located diametrically opposite across the wafer from the gas inlet port. Preferably, the spacing between the gas inlet port and the nearest edge of the wafer as well as the spacing between the exhaust port and the nearest edge of the wafer are small so that there is a reduced amount of deadspace in the system and so that control of the distribution of gases across the wafer is enhanced. Thus, it is advantageous for the reactor to include a cylindrical section that closely surrounds the sides of the wafer. The inlet port and exhaust port can be located in this cylindrical section to enable them to inject and exhaust, respectively, gases at the wafer.

A gas supply manifold is attached to the gas inlet port to enable the gas composition and flow rate to be varied across the gas inlet port, thereby enabling control over the spatial distribution of gas composition and flow rates at the wafer surface. This gas supply manifold includes a set of gas injectors each of which is connected through flow controllers to associated gas sources. The gas inlet port is preferably in the shape of a thin slot that is parallel to the wafer so that this port supplies gases to the immediate vicinity of the edge of the wafer. The exhaust port is also preferably in the shape of a thin exit slit that is parallel to the wafer so that this port exhausts gases from the immediate vicinity of the edge of the wafer.

In the gas inlet port, a number of vertical vanes can be included to provide physical strengthening of the inlet port. In addition, these vanes can prevent mixing of injected gases from different inlet jets of the gas supply manifold until these gases reach points closer to the edge of the wafer than the distance of the gas injectors from the edge of the wafer. Each pair of adjacent vanes defines the sides of a gas transport channel that prevents mixing of gases between different channels. Typically, there will be as many different gas transport channels as there are inlet gas injectors. At the inner ends of these channels, the gas inlet port narrows into a narrow inlet slit that is slightly wider than the diameter of wafers to be processed in this processing system. This enables some local mixing of the gases before these gases reach the vicinity of the wafer. This smooths the concentration and flow profiles of the inlet gases before they reach the wafer and yet enables a nonconstant concentration and flow profile to be achieved across the wafer.

A preheat susceptor ring can be included between the inlet slit and the wafer to preheat the injected gases before they reach the wafer. This ring preferably extends completely around the wafer so that it provides a symmetric temperature environment for the wafer. In a processing system in which elevated process temperatures are produced by intense light from a light source, the susceptor is selected to be of a material that is opaque to this light. It is also advantageous for this material to have a low thermal mass so that the temperature can be rapidly changed by the light sources.

If the gas flow and concentration profiles are constant across the gas inlet port, then an increased process rate results at the perimeter of the wafer. This occurs because the reactant concentrations are depleted as they flow across the wafer to process the wafer. This is particularly easy to see for the case in which a portion of these reactant gases deposit on the wafer, but it is also true for other processes, such as etching processes in which the reactant gases are used up during that process step. Therefore, in general, it is advantageous to have a greater concentration and/or a greater flow rate for the portion of the reactant gas stream that crosses near the center of the wafer. Preferably, the wafer is rotated to produce a temporally averaged, radially symmetric processing of the wafer even though the gas flow and/or concentration is not constant across the wafer.

Although the gas flow rate and wafer rotation rate are low enough that there will generally be nonturbulent gas flow within the reactor chamber, the complicated interaction between the various parameters limits the ability to accurately determine theoretically the desired flow and concentration profiles. This is particularly true in most preferred embodiments of reactors because of the complicated interaction between heating effects, rotation of the wafer, flow rates, concentrations, backflow of gases in the rotating wafer system, temperature decomposition of the gases and complex reactions between the reactant gases and the wafer. Such theoretical analysis can be a starting point, but optimization is generally achieved empirically.

### Description of the Figures

Figure 1 is a side view of a wafer processing reactor in accordance with the present invention.

Figure 2 is a top cross-sectional view of the wafer processing reactor of Figure 1 illustrating an array of heating lamps utilized to heat the wafer.

Figure 3 is a top cross-sectional view of the wafer processing reactor of Figure 1 through a plane containing a gas inlet port and a gas exhaust port.

Figure 4 is a side view of the gas supply manifold, as indicated in Figure 3.

Figure 5 is a side view cross-section of the gas inlet port, as indicated in Figure 3.

Figure 6 illustrates flow streamlines of gas from the gas inlet port to the gas outlet port

Figure 7 presents empirical plots of deposition thickness on a wafer as a function of wafer radius for several selections of gas flow rates into 7 different gas transport channels.

### Description of the Preferred Embodiment

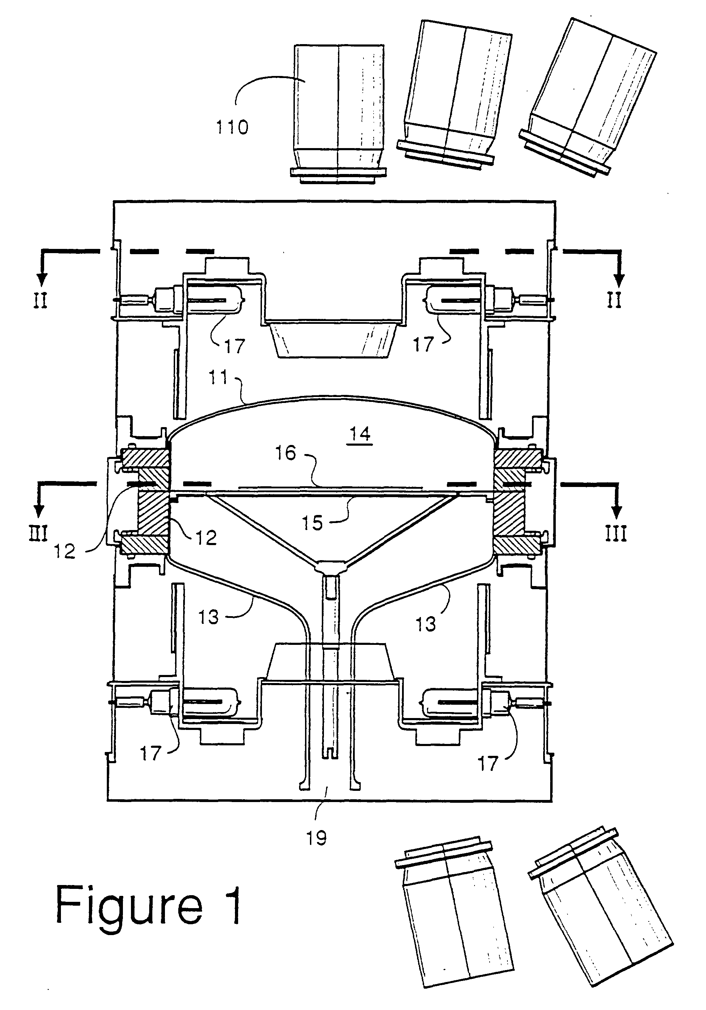

Figure 1 is a side view of a wafer processing reactor in accordance with the present invention. Walls 11-13 enclose a reaction chamber 14 in which processing of wafers takes place. A wafer pedestal 15 within this chamber can be rotated to produce axially symmetric processing of wafers by producing a time-averaged environment for a wafer 16 that is centered on the rotation axis.

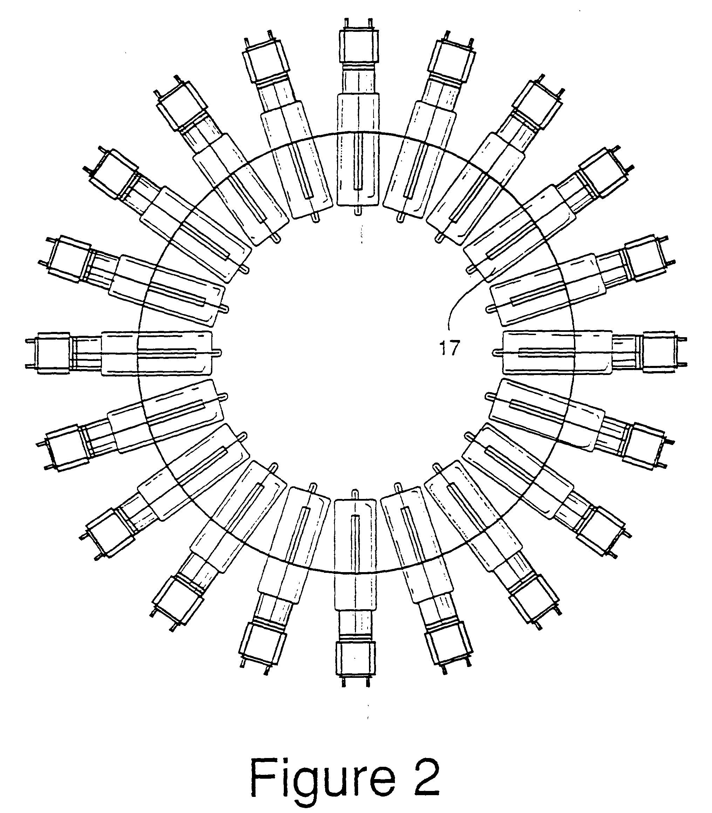

Wafer 16 is heated by means of an array of lamps 17 that are distributed in a ring centered on an axis that passes perpendicularly through wafer 16. A top cross-sectional view of these lamps is presented in Figure 2. The wafer pedestal is preferably of an opaque material that can withstand the processing temperatures so that light from lamps 17 heats the wafer even if the wafer is transparent to the light from lamps 17. In this embodiment, the pedestal is silicon carbide coated graphite.

To increase the rate at which the wafer can be thermally cycled, arrays of lamps 17 are included both above and below pedestal 15. To enable this light to reach the pedestal, walls 11 and 13 are transparent to the light from these lamps. A convenient choice of material for these walls is quartz because of its transparency, strength (to withstand pressure differences across these walls) and ability to withstand the elevated temperatures (typically 500-1,200 degrees Centigrade) utilized during wafer processing. Typical process pressures can be as low as a few 100 Pa (Torr) so at these walls need to withstand a full atmosphere of pressure. Sidewall 12 is typically a machined block of material such as quartz. In other applications, such as other CVD or etching processes, suitable choices of material include aluminum and stainless steel. Additional gases such as hydrogen or nitrogen can be injected through a gas inlet 19 into reaction chamber 14 to prevent the reactant gases from flowing into the bottom half of the process chamber. A set of infrared detectors 110 are utilized to measure the wafer temperature and provide feedback to a power source for lamps 17 to regulate the wafer temperature. A reactor of this type is illustrated in greater detail in U.S. Patent No. 5,108,792.

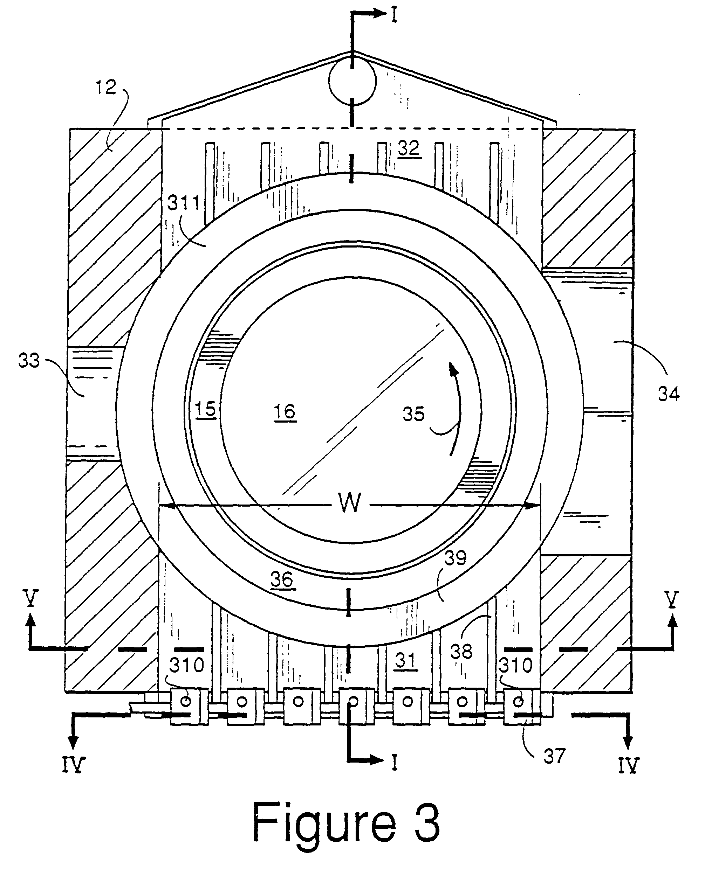

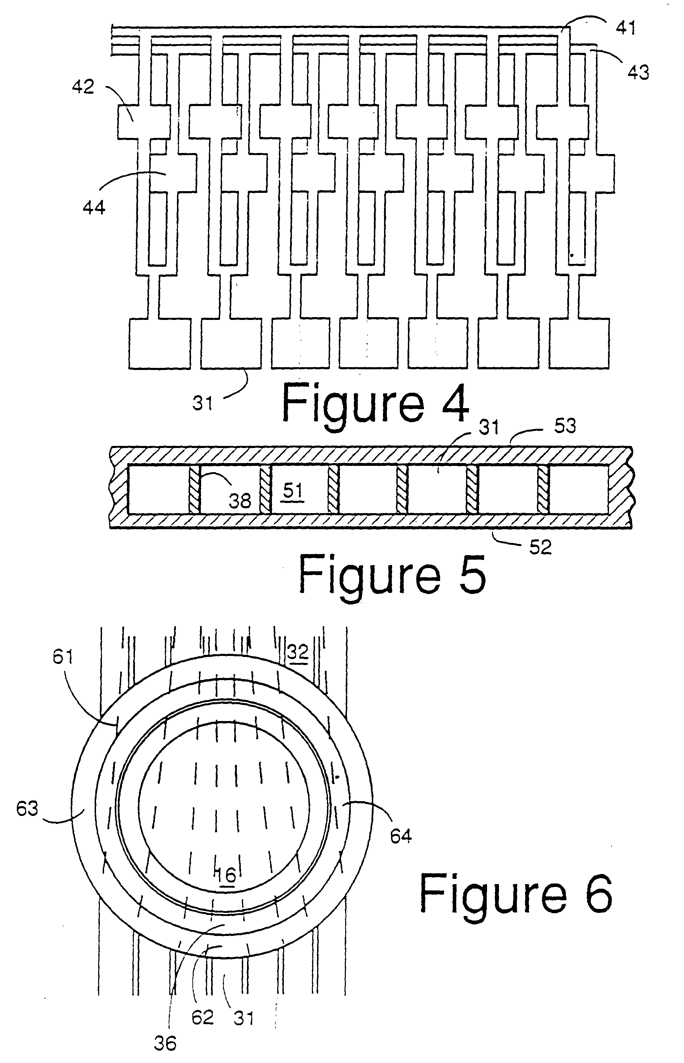

Figure 3 is a top cross-sectional view of the wafer processing reactor of Figure 1 through a plane containing a gas inlet port 31 and a gas exhaust port 32. A hole 33 is included for use by various pieces of equipment such as a thermocouple to measure the gas temperature within reaction chamber 14. A slot 34 enables wafers to be transmitted into and out of the reaction chamber. Arrow 35 illustrates that pedestal 15 and wafer 16 are rotated about an axis A that is substantially centered on the wafer and is substantially perpendicular to a top surface of the wafer. A preheat ring susceptor 36 is included to provide heating of injected gases before they reach the wafer. Although this can be achieved by a preheat susceptor that does not encircle the wafer, it is advantageous to encircle the wafer so that it experiences a more uniform processing environment. This preheat ring susceptor 36 is opaque to the light from lamps 17 and, in this embodiment, is silicon carbide coated graphite. Reactant and carrier gases are supplied into gas inlet port 31 by a gas supply manifold 37 that is illustrated in greater detail in Figure 4.

In this embodiment the gas supply manifold 37 supplies only a pair of different gases. A first of these gases is supplied from a first gas source to a first pipe 41 and a second of these gases is supplied from a second gas source to a second pipe 43. Each of these two pipes splits into seven pipes, each provided at one of a set of inlets 310 to a different channel 51 (illustrated in Figure 5 and discussed below in regard to that figure) of the gas inlet port 31. Between pipe 41 and each of the seven pipes from it to the gas inlet port channels is an associated flow controller 42. Similarly, between pipe 43 and each of the seven pipes from it to the gas inlet port channels is an associated flow controller 44. This enables the flow rate of each of these two gases to each of the seven channels to be independently controlled. The concentrations in the channels are then determined by the mix of these two gases in these channels and by the concentrations of these two gases. In other embodiments more than two pipes such as 41 and 43 can be provided to enable more control over the gas flow and concentration. For example, various carrier gases as well as multiple reactant gases can be provided. Also, fewer or greater than 7 channels can be utilized to distribute these gases.

Figure 5 is a side view cross-section of the gas inlet port 31. A set of vanes 38 extend from a bottom wall 52 to a top wall 53 of the gas inlet port and provides support for the gas inlet port These vanes also divide the gas inlet port into a set of seven channels 51 that provide the ability to prevent mixing of injected gases until a point closer to the edge of the wafer being processed. This enables greater control over the flow and concentration profiles of reactant and carrier gases across the top surface of the wafer. A typical flow profile is illustrated in Figure 6 by dashed lines 61 that indicate boundary lines between the gas flow from adjacent channels 51. This flow profile can be altered by altering the total gas flow through each of these seven channels 51. The reaction process can also be altered by changing the relative mix of gases through each of these channels.

As is illustrated in Figure 3, between the ends of the vanes 38 and the wafer is a thin slit 39 through which the reactant and carrier gases pass before entering the reactor chamber. Because the vanes do not extend into this region, the gases from adjacent channels can begin to mix, thereby smoothing out the concentration and flow profiles before these gases reach the vicinity of the wafer. This narrow slit has a width W as wide as the width of the gas inlet port 31 within the region containing the vanes. The height (i.e., the dimension of this slit perpendicular to the view of figure 3) is on the order of 3 mm so that the gases are injected into a region of small height at the wafer edge. This produces an efficient utilization of the reactant gases because this thin region will tend to flow uniformly across the reaction chamber to the exhaust port

In general, a greater flux of reactants is required in the middle channels 62 so that a relatively higher flux results near the center of the wafer than at the perimeter. This higher flux is required in these channels because the concentration is partially depleted as it passes over the peripheral region of the wafer and on to the central portion. Furthermore, the peripheral regions of the wafer interact not only with the gas from the inner channels, but also interact within regions 63 and 64 with gases supplied through the outer channels.

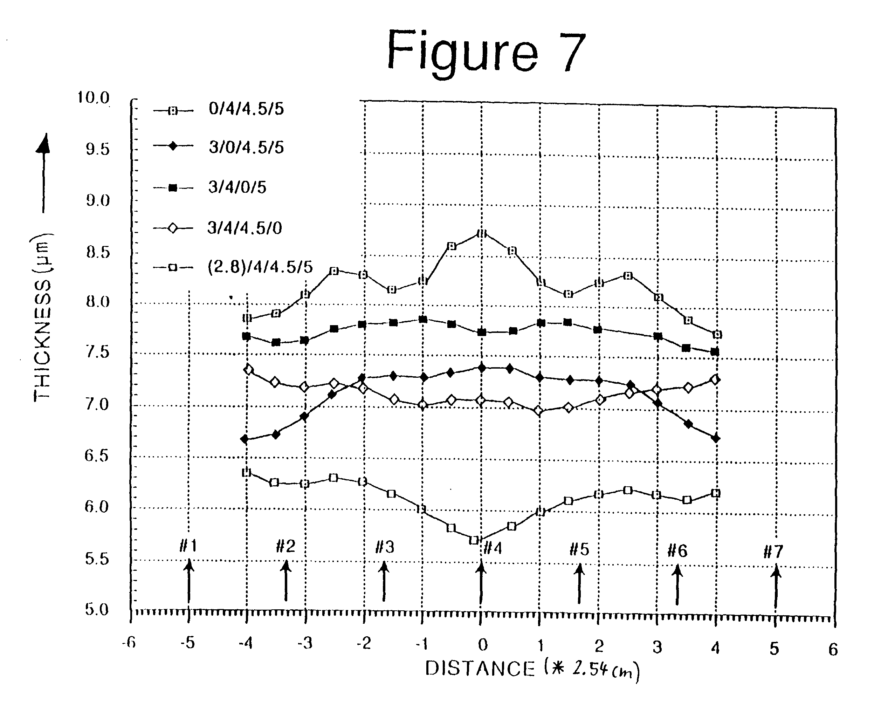

The complicated interaction between heating effects, rotation of the wafer, flow rates, concentrations, backflow of gases in the rotating wafer system, temperature, decomposition of the gases, thermal convection and complex reactions between the reactant gases and the wafer make it extremely difficult to accurately predict what combination of flow rates and concentrations will be optimal, so theoretical considerations will generally be only a starting point for the selection of the gas flow rates and concentrations through each of the channels. Because the wafer surface is heated by light from lamps 17, local convection cells can dominate local flow patterns. Empirical measurements will almost always be required to optimize the process. Figure 7 illustrates a typical set of such empirical data.

This figure represents the process of silicon deposition and displays the thickness (in µm), as a function of radial distance from the center of the wafer, of the resulting layer produced on the wafer. The arrowed numbers above the horizontal axis of said figure refer to the respective channel numbers. In the top left corner is indicated the total flow rate (in litres per minute) within each of the seven channels. Only four numbers are indicated since a symmetric pattern of relative flow rates is utilized in these tests. Thus, for the top curve, the first and seventh channels (i.e., the outermost channels) have zero gas flow, the second and sixth channels (i.e., the 2nd outermost channels) have a flow rate of 4, the third and fifth channels have a flow rate of 4.5 and the fourth channel (i.e., the central channel) has a flow rate of 5. This plot shows that the expected result that the first and seventh channels have a strong effect on the deposition over the outer regions fo the wafer. Somewhat surprisingly, the third and fourth of these curves show that the flow in the third and fifth channels has a greater effect on the thickness at the center of the wafer than does the flow rate in the central channel.

In a typical process, the total flow rate through gas inlet 19 is on the order of 8 liters per minute and the total flow rate through gas inlet port is on the order of 20-30 liters per minute. Optimal uniformity for the process of silicon deposition was achieve for relative flow rates of 11, 9, 10, 10, 10, 9, and 11 in channels 1-7, respectively. This choice produces a better uniformity than when all of these flow rates are equal. Micrometering valves and fixed orifices are utilized as flow controllers 42 and 44 to control flow rate. Other devices for controlling flow rates include mass flow controllers or other variable restrictors.

In the embodiment of figures 1-6, vanes 38 are all parallel and are directed straight ahead as can be seen in Figures 3 and 6. In alternate embodiments, the directions of these vanes can also be an adjustable process parameter. Vanes can also be placed in the slit area 39 of the inlet or the exhaust 311 to alter the flow pattern. Other variations include changes in the flow channel width W relative to the other dimensions or altering the number of flow channels used in the inlet independent of the number used in the exhaust.

## Claims

1. A wafer processing reactor comprising:
reactor chamber walls (11-13) that enclose a reaction chamber (14) within which wafers (16) are to be processed;
a gas inlet port (31) for supplying at least one process gas into said reaction chamber (14) adjacent an edge of said wafer (16) in a plane parallel to said wafer (16), said gas inlet port (31) having a width slightly wider than the diameter of the wafer (16); and being divided into a plurality of gas flow channels (51) by a plurality of vanes (38) extending to but not overlapping said wafer (16);
a gas supply manifold (37) that injects at least one process gas through a plurality of spatially separated inlets (310) into said plurality of channels (51) of said gas inlet port (31), thereby forming a plurality of separate gas streams;
each of said inlets (310) having a separate flow control means (42, 44) in the flow path from the source of process gas to one of said inlets (310), thereby providing an ability to control the gas flow spatial distribution of said at least one process gas through said gas inlet port (31),
whereby the mixing of said gas streams injected through said different inlets (310) into said different channels (51) does not occur until the distal end of said vanes (38) is reached.

2. The wafer processing reactor of claim 1, wherein said vanes (38) are parallel to each other.

3. The wafer processing reactor according to claim 1, wherein the direction of said vanes (38) with respect to each other can be changed.

4. The wafer processing reactor according to claim 1, wherein said wafers (16) are mounted on a substrate support (15) that can be rotated.

5. The wafer processing reactor according to claim 1, wherein a preheat susceptor ring (36) is mounted in such a way as to encircle the substrate support (15) to preheat the incoming gas streams.

6. A method for processing a substrate mounted horizontally within a reaction chamber comprising the steps of
mounting a substrate (16) within said chamber on a substrate support (15) that can be rotated;
mounting a preheat ring (36) so that it encircles the substrate support (15);
connecting a gas inlet source to a pipe (41) that is divided into a plurality of channels (51), said channels each having a separate flow controller (42) so as to form a plurality of gas streams from said gas;
passing each of the plurality of processing gas streams through one of a plurality of vanes (38) extending to but not overlapping the wafer to maintain separation between the gas streams across said preheat ring (36) to the surface of said substrate (16) while rotating said substrate support (15);
separately controlling the respective flows of said gas streams such that a higher flow of processing gas is directed at the center of the substrate (16) than at the perimeter of the substrate (16).

7. The method of claim 6, wherein said gas streams are preheated by the preheat ring (36) just prior to reaching the substrate (16).

## Patentansprüche

1. Waferbearbeitungsreaktor mit:
Reaktorkammerwänden (11-13), die eine Reaktionskammer (14) umschließen, in der Wafer (16) bearbeitet werden sollen;
einer Gaseinlaßmündung (31) zum Liefern von mindestens einem Prozeßgas in die Reaktionskammer (14) benachbart zu einer Kante des Wafers (16) in einer zum Wafer (16) parallelen Ebene, wobei die Gaseinlaßmündung (31) eine Breite aufweist, die geringfügig breiter ist als der Durchmesser des Wafers (16); und durch eine Vielzahl von Flügeln (38), die sich zum Wafer (16) erstrecken, aber diesen nicht überlappen, in eine Vielzahl von Gasdurchflußkanälen (51) unterteilt ist;
einem Gaszufuhr-Rohrverteiler (37), der mindestens ein Prozeßgas durch eine Vielzahl von räumlich getrennten Einlässen (310) in die Vielzahl von Kanälen (51) der Gaseinlaßmündung (31) einleitet, wodurch eine Vielzahl von separaten Gasströmen gebildet werden;
wobei jeder der Einlässe (310) ein separates Durchflußregelmittel (42, 44) im Strömungsweg von der Prozeßgasquelle zu einem der Einlässe (310) aufweist, wodurch eine Fähigkeit vorgesehen wird, die räumliche Gasströmungsverteilung des mindestens einen Prozeßgases durch die Gaseinlaßmündung (31) hindurch zu regeln,
wobei das Mischen der Gasströme, die durch die verschiedenen Einlässe (310) in die verschiedenen Kanäle (51) eingeleitet werden, nicht stattfindet, bis das ferne Ende der Flügel (38) erreicht ist.

2. Waferbearbeitungsreaktor nach Anspruch 1, wobei die Flügel (38) zueinander parallel sind.

3. Waferbearbeitungsreaktor nach Anspruch 1, wobei die Richtung der Flügel (38) relativ zueinander geändert werden kann.

4. Waferbearbeitungsreaktor nach Anspruch 1, wobei die Wafer (16) auf einem Substratträger (15) befestigt werden, der gedreht werden kann.

5. Waferbearbeitungsreaktor nach Anspruch 1, wobei ein Vorheiz-Suszeptorring (36) derart montiert ist, daß er den Substratträger (15) umgibt, um die einströmenden Gasströme vorzuheizen.

6. Verfahren zum Bearbeiten eines Substrats, das horizontal in einer Reaktionskammer befestigt ist, mit den Schritten
Befestigen eines Substrats (16) innerhalb der Kammer auf einem Substratträger (15), der gedreht werden kann;
Montieren eines Vorheizrings (36) so, daß er den Substratträger (15) umgibt;
Verbinden einer Gaseinlaßquelle mit einem Rohr (41), das in eine Vielzahl von Kanälen (51) unterteilt ist, wobei die Kanäle jeweils einen separaten Durchflußregler (42) aufweisen, um eine Vielzahl von Gasströmen aus dem Gas zu bilden;
Leiten von jedem der Vielzahl von Bearbeitungsgasströmen durch einen von einer Vielzahl von Flügeln (38), die sich zum Wafer erstrecken, aber diesen nicht überlappen, um die Trennung zwischen den Gasströmen aufrechtzuerhalten, über den Vorheizring (36) zur Oberfläche des Substrats (16), während der Substratträger (15) gedreht wird;
separates Regeln der jeweiligen Durchflüsse der Gasströme derart, daß ein stärkerer Durchfluß von Bearbeitungsgas in die Mitte des Substrats (16) gelenkt wird als an den Umfang des Substrats (16).

7. Verfahren nach Anspruch 6, wobei die Gasströme durch den Vorheizring (36) direkt vor dem Erreichen des Substrats (16) vorgeheizt werden.

## Revendications

1. Réacteur de traitement de tranches, comprenant :
des parois de chambre de réacteur (11 à 13) qui enferment une chambre de réaction (14) à l'intérieur de laquelle des tranches (16) doivent être traitées,
un orifice d'entrée de gaz (31) destiné à fournir au moins un gaz de traitement dans ladite chambre de réaction (14) de façon contiguë à un bord de ladite tranche (16) dans un plan parallèle à ladite tranche (16), ledit orifice d'entrée de gaz (31) présentant une largeur légèrement plus grande que le diamètre de la tranche (16), et étant divisé en une pluralité de canaux d'écoulement de gaz (51) par une pluralité d'aubes (38) s'étendant vers ladite tranche (16) mais ne recouvrant pas celle-ci,
un collecteur d'alimentation en gaz (37) qui injecte au moins un gaz de traitement par l'intermédiaire d'une pluralité d'entrées (310) séparées dans l'espace dans ladite pluralité de canaux (51) dudit orifice d'entrée de gaz (31), en formant ainsi une pluralité de flux de gaz séparés,
chacune desdites entrées (310) comportant un moyen séparé de commande d'écoulement (42, 44) dans le trajet d'écoulement de la source de gaz de traitement à l'une desdites entrées (310), en procurant ainsi la possibilité de commander la distribution spatiale de l'écoulement de gaz dudit au moins un gaz de traitement au travers dudit orifice d'entrée de gaz (31),
grâce à quoi le mélange desdits flux de gaz injectés par l'intermédiaire desdites différentes entrées (310) dans lesdits différents canaux (51) ne se produit pas jusqu'à ce que l'extrémité distale desdites aubes (38) soit atteinte.

2. Réacteur de traitement de tranches selon la revendication 1, dans lequel lesdites aubes (38) sont parallèles les unes aux autres.

3. Réacteur de traitement de tranches selon la revendication 1, dans lequel la direction desdites aubes (38) les unes par rapport aux autres peut être modifiée.

4. Réacteur de traitement de tranches selon la revendication 1, dans lequel lesdites tranches (16) sont montées sur un support de substrat (15) qui peut être entraîné en rotation.

5. Réacteur de traitement de tranches selon la revendication 1, dans lequel un anneau de suscepteur de préchauffage (36) est monté de manière à encercler le support de substrat (15) afin de préchauffer les flux de gaz entrants.

6. Procédé de traitement d'un substrat monté horizontalement à l'intérieur d'une chambre de réaction comprenant les étapes consistant à
monter un substrat (16) à l'intérieur de ladite chambre sur un support de substrat (15) qui peut être entraîné en rotation,
monter un anneau de préchauffage (36) de sorte qu'il encercle le support de substrat (15),
raccorder une source d'entrée de gaz à une tubulure (41) qui est divisée en une pluralité de canaux (51), lesdits canaux comprenant chacun un contrôleur d'écoulement séparé (42) de façon à former une pluralité de flux de gaz à partir dudit gaz,
faire passer chacun parmi la pluralité de flux de gaz de traitement par l'une d'une pluralité d'aubes (38) s'étendant vers la tranche mais ne recouvrant pas celle-ci afin de maintenir une séparation entre les flux de gaz à travers ledit anneau de préchauffage (36) vers la surface dudit substrat (16) tout en faisant tourner ledit support de substrat (15),
commander séparément les écoulements respectifs desdits flux de gaz de sorte qu'un écoulement de gaz de traitement dirigé sur le centre du substrat (16) soit plus élevé qu'au niveau du périmètre du substrat (16).

7. Procédé selon la revendication 6, dans lequel lesdits flux de gaz sont préchauffés par l'anneau de préchauffage (36) juste avant d'atteindre le substrat (16).
